Europäisches Patentamt

European Patent Office

Office européen des brevets

(19)

(11) Publication number: **0 078 219**
**A2**

## EUROPEAN PATENT APPLICATION

(21) Application number: **82401969.9**

(22) Date of filing: **26.10.82**

(51) Int. Cl.³: **G 01 R 31/28**

(30) Priority: **26.10.81 US 314644**

(43) Date of publication of application:
**04.05.83 Bulletin 83/18**

(84) Designated Contracting States:
**DE FR GB IT NL SE**

(71) Applicant: **FAIRCHILD CAMERA & INSTRUMENT CORPORATION**
**464 Ellis Street**
**Mountain View California 94042(US)**

(72) Inventor: **Garcia, Rudolfo F.**
**388 Avenida Palmas**
**San Jose California 95123(US)**

(74) Representative: **Chareyron, Lucien et al,**
**Schlumberger Limited Service Brevets 42, rue Saint-Dominique**
**F-75340 Paris Cedex 07(FR)**

(54) Automatic de-skewing of pin electronics interface circuits in electronic test equipment.

(57) A plurality of pin electronics interface circuits are coupled to pins of an electronic device being tested to force stimuli signals representing logic states or other parameters on input pins of the device under test and monitor the resultant conditions on output pins of the device under test. Each pin electronics interface circuit includes a node to be coupled to a pin of the device under test, a driver connectable to the node by a first switch, a comparator connected to the mode by a second switch, and a third switch connecting the node to the node of a subsequent testing circuit.

The skew of a signal supplied to or received from a pin of the device under test is determined by connecting the comparator associated with that pin to the driver of a reference interface circuit and measuring the skew of the comparator, and by connecting the driver associated with the node to comparator of a reference pin electronics interface circuit and measuring the skew associated with that driver. By daisy chaining subsequent pin electronics interface circuits to preceding interface circuits, the skew of any interface circuit with respect to the preceding interface circuit may be determined, and related to the reference interface circuit.

FIG. 2

## Automatic De-Skewing Of Pin Electronics
## Interface Circuits In Electronic Test Equipment

### Background of the Invention

#### Field of the Invention

This invention relates to electronic circuits, and in particular to a method and apparatus for automatically de-skewing a series of pin electronics interface circuits in an automated electronic test system.

#### Description of the Prior Art

In automated electronic test equipment a plurality of pin electronics interface circuits are coupled to the pins or other nodes of an electronic device being tested to force stimuli signals controlled by a test system computer onto the device under test and monitor the resultant conditions. Typically, the stimuli signals represent logic states or analog voltages or currents which are desired to be impressed on the input pins of the device under test as a parallel pattern, and the resulting output pattern is checked in parallel.

The pin electronics interface circuits function as computer controlled interface circuits between the computer of the test system and the individual pins of the device being tested. The pin electronics interface circuits receive reference voltages and digital data from other circuits in the test system and then through an input driver switch these reference voltages or digital data onto the desired pin of the device under test in accordance with a stored program in the test system computer. The pin electronics interface circuits also receive reference voltages or currents which a comparator circuit within the pin electronics interface circuit uses to compare to the voltages or currents received from the output pins of the device under test. The output signals from the comparator circuit in the pin electronics interface circuit are returned to the test system mainframe where they are checked in accordance with a

**0078219**

stored program for the proper responses. In this manner, individual electronic components, for example, semiconductor memories or other integrated circuits, may be individually tested to assure that they meet whatever standard or specifications the ultimate user of the integrated circuit desires. A more detailed description of the design and operation of a pin electronics interface circuit may be found in "Sentry*(TM) High Speed and Clock Driver Pin Electronics," Reference Manual, Part No. 57000000, published by Fairchild Systems Technology, September, 1977.

One problem which arises in the operation of such automated test equipment is that differences in the time delay propagation of signals through the pin electronics interface circuits and coupling circuitry to and from the device under test result in a time skewing of both the stimuli signals and the monitored conditions. Thus, it is difficult to impress the stimuli signals on all input pins as a simultaneous parallel pattern of logic states, currents or voltages, and to monitor the condition of the signals from the output terminals simultaneously.

One technique used in automatic test systems to de-skew the pulses in each pin electronics interface circuit relative to a reference circuit is shown in United States Patent 4,092,589 entitled "High-Speed Testing Circuit" by Chau, et al. and assigned to Fairchild Camera and Instrument Corporation, the assignee of this invention. In that patent, a resistor/capacitor network in which the resistors are potentiometers is used to adjust the leading and trailing edge time delay of the data pulse supplied by the driver or received from the comparator in the pin electronics interface circuit. Adjustment of one variable resistor will advance or delay the trailing edge of the pulse while advancement of the other variable resistor will advance or delay the leading edge of the pulse. Unfortunately, de-skewing the pin electronics interface circuit using variable resistors requires manual adjustments and testing of each testing circuit. In such an operation, a technician using an oscilloscope or other apparatus must compare the driver

*Mark of Fairchild Camera and Instrument Corporation

and comparator signals from each testing circuit with the driver and comparator signals from a reference circuit and then manually adjust the potentiometers to de-skew the testing circuit. Such an approach is time consuming and expensive.

The potentiometers of such a de-skewing apparatus may be replaced by digital-to-analog converters driving a comparator or other well-known apparatus to thereby provide de-skewing under control of the test system computer. This approach, however, does not make the de-skewing operation fully automatic and totally under computer control because the skew of signals from each driver and comparator must be measured to determine what corrections should be applied.

One prior art technique for determining the time skew of both the stimuli signals and the monitored conditions is to connect each pin electronics interface circuit to a standard pin electronics interface circuit and measure the skew relative to the standard circuit. A method of accomplishing this is to use a coaxial relay multiplexer. This technique is used, for example, in the Takeda Riken automatic test system manufactured by that company. In principle in that machine, 1:4 relay multiplexers are used, and four pin electronics interface circuits are connected to each relay multiplexer. The output signals from four such multiplexers are in turn connected as inputs to another 1:4 multiplexer, and the output signals from four of those multiplexers are connected to supply input signals to yet another series of 1:4 multiplexers. Eventually, only a single 1:4 multiplexer is needed and it is connected to the reference pin electronics interface circuit. In this manner, by selectively controlling the banks of 1:4 multiplexers, any one of the pin electronics interface circuits may be connected to the reference circuit and the skew of that circuit determined. Unfortunately, this technique suffers from several disadvantages. The technique requires a large number of expensive coaxial multiplexers. For example, for sixty pin electronics interface circuits, twenty coaxial multiplexers are required. Use of such a large numbers of multiplexers lessens reliability and greatly **0078219**
increases the physical size of the test apparatus. Although the
number of multiplexers may be decreased by going to a higher
multiplexing level, for example, 1:8, the capacitive loading becomes
correspondingly greater.


## SUMMARY OF THE INVENTION

It is a general object of the present invention to provide
an improved method and apparatus for automatically measuring the
skew characteristics of each pin electronics interface circuit and
correcting for the detected skew characteristics.

In one embodiment, each one of a pluarlity of testing
circuits, each testing circuit being connected to a corresponding
node, comprises: driver means switchably connected by first switch
means to the corresponding node for supplying signals to the node,
comparator means switchably connected by second switch means to the
corresponding node for receiving signals from the node, and third
switch means connected between the corresponding node and the
corresponding node of another testing circuit.

In another embodiment a method of measuring the skew of
each of a plurality k, k+1, k+2 ... k+n of testing circuits which
include driver means and comparator means wherein the method of
measuring the skew of the k+1 circuit and the k+2 circuit relative
to the k circuit comprises: connecting the k driver means to the
k+1 comparator means; measuring the skew of the k+1 comparator
means; connecting the k+1 driver means to the k comparator means;
measuring the skew of the k+1 driver means; connecting the k+1
driver means to the k+2 comparator means; measuring the skew of the
k+2 comparator means relative to the k+1 driver means; connecting
the k+2 driver means to the k+1 comparator means; measuring the skew
of the k+2 driver means relative to the k+1 comparator means; and
compensating the measure skew of the k+2 testing circuit for the
measured skew of the k+1 testing circuit.

BRIEF DESCRIPTION OF THE DRAWINGS

Figure 1 is a block diagram of a test system fabricated according to the invention.

Figure 2 is a more detailed block diagram of the testing circuit of this invention.


DESCRIPTION OF THE PREFERRED EMBODIMENT

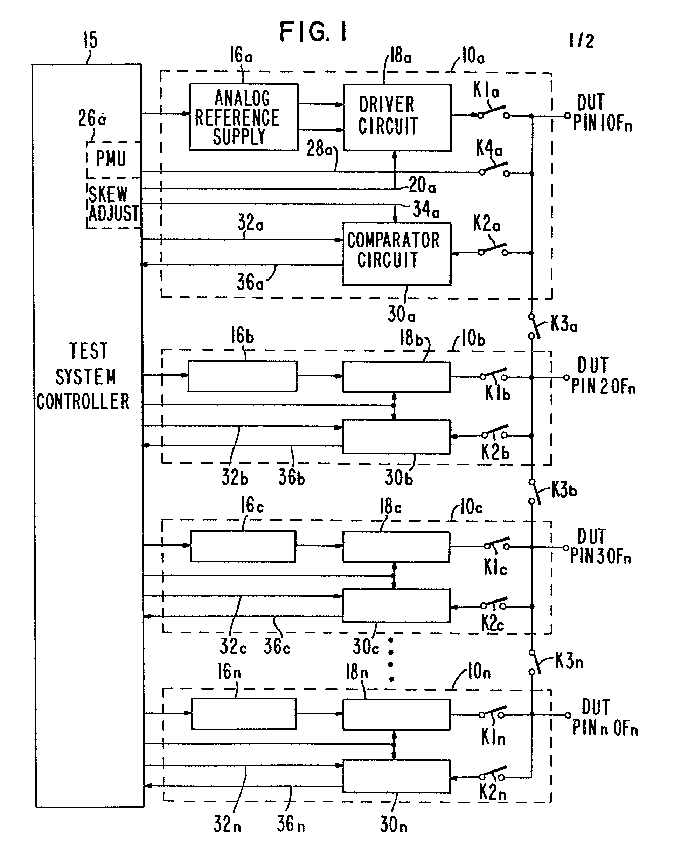

Figure 1 is a block diagram of a test system fabricated according to this invention. As shows in Figure 1, a plurality of pin electronics interface circuits 10a, 10b, 10c ... 10n are coupled between the controller 15 of a test system and n pins of a device under test (DUT). Test system controllers such as depicted in Figure 1 are commercially available, and one such apparatus is the Fairchild Sentry* system manufactured by the assignee of this invention. The test system controller 15 supplies a pattern of pulses to the individual testing circuits 10 by means of various interconnections with the testing circuits. In operation, one test circuit 10 is connected to each terminal of the multiterminal DUT. Each testing circuit 10 is capable of being operated by controller 15 in one of several modes depending upon whether the test circuit 10 is coupled to a DUT input signal terminal, DUT output signal terminal, or other various function or supply terminals. Thus, a DUT having sixteen terminals or pins would be tested in a fixture containing sixteen identical testing circuits 10 controlled by a single test system controller 15 containing a stored program specifically written to test the particular DUT.

For example, if testing circuit 10a is coupled to a signal input terminal of the DUT, controller 15 will first close relay K1 to connect the test stimuli section of cir-


*Trademark of FAIRCHILD CAMERA AND INSTRUMENT CORPORATION

cuit 10 to terminal 1 of the DUT. This section of the testing circuit 10 contains an analog reference supply 16a which in response to signals from controller 15 generated according to a program stored in the test system produces two levels of DC reference voltages. These two levels of reference voltages are supplied to driver circuit 18a which switches between the two levels to produce a pattern of pulses in accordance with the data supplied to driver circuit 18a on line 20a. As will be explained, a skew adjustment is performed to the data on line 20a before it is supplied to driver circuit 18a to ensure that the pulses applied to pin 1 of the DUT are correctly timed with respect to the pulses supplied to, and measurements taken from, other pins of the DUT. The test circuits 10 are also capable of performing parametric tests on the DUT. During such testing, precision measurement unit (PMU) 26 located within the test system controller 15 supplies desired voltages or currents to the appropriate pin of the DUT. In such operation, the controller closes only relay contact K4a to enable coupling of pin 1 of the DUT to PMU 26 via line 28a. Although not shown in Figure 1, similar PMU's 26b, 26c, . . . 26n may apply controlled signals to corresponding other pins of the DUT, or one or more PMU's may be multiplexed to the pins.

For the testing circuits 10 coupled to signal output terminals of the DUT, the test system controller 15 closes only relay contact K2 so that DUT output signals generated in response to the test stimuli signals from other testing circuits 10 driven by controller 15 will be applied directly to a comparator such as comparator 30b. The comparator will also receive a predicted signal from controller 15 via line 32. In addition, a data input signal is transmitted to comparator 30 through line 34 to switch the output signals of the comparator in accordance with the input data applied to the DUT. As will be explained, the timing of the signal on line 34 is adjusted to compensate for skew inherent in the comparator, propagation delays, or other effects on the signal timing. The output of the comparator 30 is returned to the test system computer via line 36. The matching of the signals on line 36 with the predicted signals in the test system controller 15 will cause the test system controller 15 to register either acceptance or rejection of the DUT, or to specify its quality.

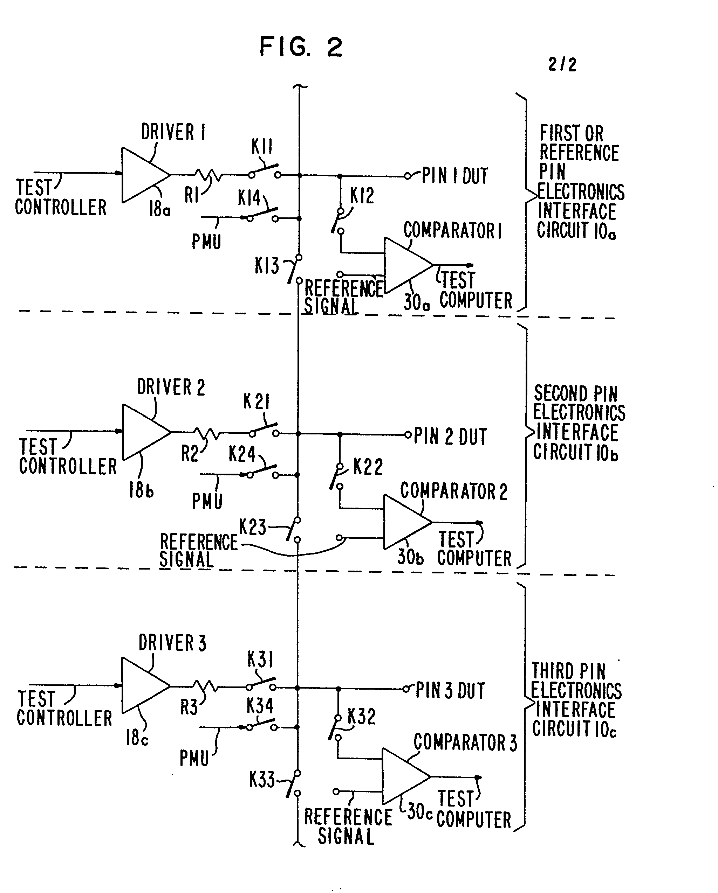

Figure 2 is a more detailed schematic of a portion of each of the pin electronics interface circuits of this invention. Shown in Figure 2 are a sequence of three pin electronics interface circuits; however, as many interface circuits as desired may be used. First or reference interface circuit 10a includes a driver 18a connected through resistor R1 and reed relay K11 to pin 1 of the DUT. A first comparator 30a is connected to pin 1 of the DUT via reed relay K12. A PMU may also be connected to pin 1 of the DUT via reed relay K14. The open or closed state of the reed relays is controlled by the test system controller 15.

Unlike interface circuits of the prior art, however, the interface circuits shown in Figure 2 are coupled together via switching devices K13, K23 and K33, typically reed relays. It is these reed relays, or other switching means, which enable the simplified measurement of the skew of each of the pin electronics interface circuits. As explained above, prior art techniques for determining the skew of interface circuits 10 with respect to a reference circuit 10a have required cumbersome expensive apparatus. In the preferred embodiment of this invention, the skew of circuit 10b with reference to circuit 10a may be determined as follows, assuming driver 18a and comparator 30a to be the reference devices. Driver 18a is connected to comparator 30b by closing relays K11, K13 and K22. All other relays are open. The parasitic load imposed by the open relays is that of relays K14, K12, K21, K24, and K23. A test within test system controller 15 is next performed and the leading and trailing edge skew determined in a well-known manner, for example by repetitive sampling, using high speed counters, or otherwise. The measured skew will have two components--the intrinsic skew of the comparator plus the path delay through relay K13. Because the path delay is a relative constant determined by the dimensions of the printed circuit on the pin electronics interface circuit printed circuit board, it will not vary significantly from one PC board to the next. That path delay may be measured or computed in a well-known manner and then subtracted from the leading and trailing edge skew measured to give an accurate indication of the leading and trailing edge skew inherent within comparator 30b.

Next, the relays are reconfigured to connect the pin 2 driver 18b to the pin 1 comparator 30a. This is accomplished by closing relays K21, K13 and K12. The functional exercise is again performed and the leading and trailing edge skew are determined. The fixed path delay resulting from relay K13 is removed to thereby provide a correct indication of the skew inherent in pin 2 driver 18b relative to pin 1 (or the reference circuit). At the completion of this functional exercise the test system controller 15 will have four parameters (the leading and trailing edge skew of the pin 2 driver 18b and the leading and trailing edge skew of the pin 2 comparator 30b) which fully define the skew behavior of pin 2 in relationship to pin 1.

Next, the reference pin (pin 1) is electrically removed from the circuit by having all of the relays in circuit 10a opened. The pin 2 driver 18b is then connected to the pin 3 comparator 30c by closing relays K21, K23 and K32. The functional exercise is again repeated and the skew measurement made. The skew will again contain the path delay of relay K23 which is removed. The resultant measurements provide an indication of the skew of the pin 3 comparator referenced to the pin 2 driver. Based on the previous measurements, however, the skew behavior of the pin 2 driver relative to the pin 1 comparator is already known. Therefore, the skew of the pin 3 comparator relative to the pin 1 comparator is known.

The pin 2 comparator 30b is then connected to the pin 3 driver 18c via relays K31, K23, and K22. All other relays are opened. The functional exercise is again performed and the skew of the pin 3 driver relative to the pin 2 comparator is measured.  In the same manner as before, this measurement can be traced to the skew of the reference pin 1 driver because by a previous measurement the skew of the pin 2 comparator has already been determined with reference to the pin 1 driver.  In a similar fashion, subsequent pins may be tested against previous pins and the skew measurements continued until the skew behavior of all pins is determined.

When very large numbers of pins are to be de-skewed, however, small errors in the "daisy chain" approach described above may accumulate to make subsequent measurements less and less accurate.  This difficulty may be overcome by periodically testing a subsequent pin electronics interface circuit against the reference circuit 10a by means of an additional relay directly connecting the reference interface circuit to the desired interface circuit.  For example, additional relays may be provided to directly connect circuits 15, 30, and 45 to circuit 1 in a 60 pin test system.  In this manner four direct connections to the reference circuit are provided.

The method and apparatus of this invention has several advantages over the techniques of the prior art. The method and apparatus provide a low cost means of de-skewing numerous pin electronics interface circuits without requiring coaxial multiplexers.  The method provides a relatively low capacitance loading over other methods, and requires only one additional reed relay per pin.  The path delays inherent in the system are relatively easy to control by virtue of being inherent within the layout of the printed circuit board upon which the various components are mounted.

Although a preferred embodiment of the method and apparatus of this invention has been described above, it will be apparent to those skilled in the art that numerous variations may be made without departing from the spirit and scope of the invention as defined by the appended claims. For example, the nodes may be "daisy chained" together with all even numbered nodes forming one chain and odd numbered nodes forming a second chain, or in any other fashion, for example, every third node or any other group of nodes.

WHAT IS CLAIMED IS:

1.  A method of measuring the skew of each of a plurality k, k+1, k+2 ... k+n of testing circuits which include driver means and comparator means wherein the method of measuring the skew of the k+1 circuit and the k+2 circuit relative to the k circuit is characterized by:

connecting the k driver means to the k+1 comparator means;

measuring the skew of the k+1 comparator means;

connecting the k+1 driver means to the k comparator means;

measuring the skew of the k+1 driver means;

connecting the k+1 driver means to the k+2 comparator means;

measuring the skew of the k+2 comparator means relative to the k+1 driver means;

connecting the k+2 driver means to the k+1 comparator means;

measuring the skew of the k+2 driver means relative to the k+1 comparator means; and

compensating the measure skew of the k+2 testing circuit for the measured skew of the k+1 testing circuit.

2.  The method of Claim 1 characterized in that each testing circuit further comprises a node switchably connectable by first switch means to the driver means, by second switch means to the comparator means and by third switch means to the node of the subsequent testing circuit.

3.  The method of Claim 2 characterized in that the step of connecting the k driver means to the k+1 comparator means comprises:

closing the first and third switch means of the k testing circuit; and

closing the second switch means of the k+1 testing circuit.

4.    The method of Claim 2 or 3 characterized in that the step of connecting the k+1 driver means to the k comparator means comprises:
closing the first switch means of the k+1 testing circuit; and
closing the second and third switch means of the k testing circuit.

5.    The method of any one of Claims 1-4 characterized by compensating the measured skew of the k+1 comparator means and the k+1 driver means for any propogation delay of the third switch means.

6.    The method of Claim 5 characterized by compensating the measured skew of the k+2 comparator means and the k+2 driver means for any propagation delay of the third switch means.

7.    The method of claim 5 or 6 characterized by storing the compensated measured skew in a memory means connected to the plurality of testing circuits.

8.    The method of claim 7 characterized by:
connecting a terminal of a device under test to at least one node of a selected testing circuit; and
using the stored skew to control at least one of the driver means and the comparator means of the selected testing circuit.

9.    A plurality of testing circuits, each connected to a corresponding node, each testing circuit characterized by:
driver means switchably connected by first switch means to the node for supplying signals to the node;

comparator means switchably connected by second switch means to the node for receiving signals from the node; and

third switch means connected between the node and the corresponding node of another testing circuit.

10. Apparatus as in Claim 9 characterized in that each of the first, second and third switch means comprise reed relays.

11. Apparatus of Claim 9 characterized in that:

during a first time interval the driver means of a first testing circuit is connected to the comparator means of a second testing circuit; and

during a second time interval the driver means of the second testing circuit is connected to the comparator means of the first testing circuit.

12. Apparatus of Claim 11 characterized in that the driver means of the first testing circuit is connected to the comparator means of the second testing circuit by the first and third switch means of the first testing circuit and by the second switch means of the second testing circuit.

13. Apparatus of Claim 11 or 12 characterized in that the driver means of the second testing circuit is connected to the comparator means of the first testing circuit by the first switch means of the second testing circuit and by the second and third switch means of the first testing circuit.

FIG. 1

## FIG. 2

FIRST OR REFERENCE PIN ELECTRONICS INTERFACE CIRCUIT 10a

SECOND PIN ELECTRONICS INTERFACE CIRCUIT 10b

THIRD PIN ELECTRONICS INTERFACE CIRCUIT 10c